# EUROPEAN PATENT APPLICATION

(11) **EP 4 648 594 A1**
(43) Date of publication of application: **12.11.2025**
(21) Application number: 25173585.8
(22) Date of filing: 30.04.2025
(51) Int. Cl.: H10K 59/80, H10K 102/00

(54) **DISPLAY DEVICE AND METHOD OF MANUFACTURING THE SAME**

(30) Priority: 09.05.2024 KR 20240061331
(71) Applicant: Samsung Display Co., Ltd., Yongin-si, Gyeonggi-do 17113 (KR)
(72) Inventor: PARK, Hyun Sang, 17113 Giheung-gu, Yongin-si, Gyeonggi-do (KR); KIM, Young Hae, 17113 Giheung-gu, Yongin-si, Gyeonggi-do (KR); RYU, Do Hyung, 17113 Giheung-gu, Yongin-si, Gyeonggi-do (KR); YU, Jae Young, 17113 Giheung-gu, Yongin-si, Gyeonggi-do (KR); LEE, Jong Soo, 17113 Giheung-gu, Yongin-si, Gyeonggi-do (KR); JANG, Yong Seong, 17113 Giheung-gu, Yongin-si, Gyeonggi-do (KR); JUNG, Wu Hyeon, 17113 Giheung-gu, Yongin-si, Gyeonggi-do (KR)
(74) Representative: Dr. Weitzel & Partner

(57) **Abstract**

A display device may include a display panel including at least one area that is curved, and a clad layer disposed under the display panel and overlapping the curved area of the display panel, the clad layer having multiple metal layers including different metals clad bonded to each other, and a surface of the clad layer adjacent to the display panel overlaps an entirety of the display panel.

## Description

The invention relates to a display device of which an area (e.g., single area) is curved and a method of manufacturing the same.

Recently, as interest in an information display increases and an effort for securing a wider display area continues, research and development on a display device in which one area is curved and a method of manufacturing the same are continuously being conducted.

An object to be solved by the invention is to provide a display device having a wider display area without deformation of a display panel.

**Another** object to be solved by the invention is to provide a method of manufacturing the display device which molds a display panel without deformation.

The objects of the invention are not limited to the object described above, and other technical objects which are not described will be clearly understood by those skilled in the art from the description below.

According to an embodiment of the invention, a display device includes a display panel that includes a curved area, and a clad layer disposed under the display panel, overlapping the curved area of the display panel, and having a plurality of metal layers including different metals that are clad bonded to each other, and a surface of the clad layer adjacent to the display panel overlaps an entirety of the display panel.

Clad bonding in the sense of the present invention may be also described as bonding by cladding. Such cladding may be reached for example be extrusion of the different metal layers of the clad layer through a die, or for example by pressing or rolling the different metal layers together, thereby applying pressure. Such cladding may be different from fusion welding or gluing.

In an embodiment, the display panel may include a main area, a plurality of auxiliary areas curved downward from an edge portion of the main area, and a corner area disposed where neighboring ones of the plurality of auxiliary areas meet.

In an embodiment, the clad layer may overlap the plurality of auxiliary areas and the corner area.

In an embodiment, the clad layer may include a first metal layer including a first metal, a second metal layer disposed on the first metal layer and including a second metal different from the first metal, and a third metal layer disposed on the second metal layer and including the first metal.

In an embodiment, a strength of the first metal may be greater than a strength of the second metal.

In an embodiment, a ductility of the second metal may be greater than a ductility of the first metal.

In an embodiment, the first metal may include at least one of nickel and stainless steel.

In an embodiment, the second metal may include copper.

In an embodiment, the first metal layer, the second metal layer, and the third metal layer may overlap an entirety of the display panel.

In an embodiment, the first metal layer and the third metal layer may overlap an entirety of the display panel, and the second metal layer may overlap the plurality of auxiliary areas and the corner area of the display panel in a plan view without overlapping the main area.

According to embodiments of the invention, a method of manufacturing a display device may include forming a display panel, forming a clad layer under the display panel, the clad layer may include a plurality of metal layers including different metals that are clad bonded to each other, and forming a curved area by thermoforming the display panel and the clad layer, and a surface of the clad layer adjacent to the display panel may overlap an entirety of the display panel.

In an embodiment, the method may further include attaching the clad layer to the display panel after the forming of the clad layer.

In an embodiment, in the forming of the curved area, the display panel comprises a main area, a plurality of auxiliary areas curved downward from an edge portion of the main area, and a corner area disposed where neighboring ones of the plurality of auxiliary areas meet.

In an embodiment, the clad layer may overlap the plurality of auxiliary areas and the corner area.

In an embodiment, the forming of the clad layer may include forming a first metal layer, forming a second metal layer on the first metal layer, forming a third metal layer on the second metal layer, and clad bonding the first metal layer, the second metal layer, and the third metal layer to each other by rolling the first metal layer, the second metal layer, and the third metal layer.

In an embodiment, the first metal layer may include a first metal, the second metal layer may include a second metal different from the first metal, and the third metal layer may include the first metal.

In an embodiment, a strength of the first metal may be greater than a strength of the second metal.

In an embodiment, a ductility of the second metal may be greater than a ductility of the first metal.

In an embodiment, the first metal layer, the second metal layer, and the third metal layer may overlap an entirety of the display panel.

In an embodiment, the first metal layer and the third metal layer may overlap an entirety of the display panel, and the second metal layer may overlap the plurality of auxiliary areas and the corner area of the display panel in a plan view without overlapping the main area.

Specific details of other embodiments are included in the detailed description and drawings.

According to the embodiment described above, since the clad layer in which two or more metals are clad bonded is disposed and thermoformed under the display panel, deformation of the display panel in case of thermoforming the clad layer may be prevented. Therefore, as the display panel may not be deformed and may be curved with a relatively high curvature, a dead space disposed at an edge portion of the display panel may be reduced in a plan view.

An effect according to embodiments is not limited to the content exemplified above, and further various effects are included in the specification.

### BRIEF DESCRIPTION OF THE DRAWINGS

The above and other features of the invention will become more apparent by describing in further detail embodiments thereof with reference to the accompanying drawings, in which:
FIG. 1 is a schematic block diagram illustrating an embodiment of a display device according to the invention;
FIG. 2 is a schematic block diagram illustrating an embodiment of one of sub-pixels of FIG. 1;
FIG. 3 is a schematic plan view illustrating an embodiment of the display device of FIG. 1;
FIG. 4 is a schematic plan view illustrating an embodiment of the display device of FIG. 3;
FIG. 5 is a schematic cross-sectional view taken along line I-I' of FIG. 4;
FIG. 6 is a schematic cross-sectional view illustrating an embodiment of a display panel of FIG. 5;
FIG. 7 is an exploded schematic plan view illustrating an embodiment of the display panel and a clad layer of FIG. 5;
FIG. 8 is a schematic cross-sectional view illustrating an embodiment of the clad layer of FIG. 7;
FIG. 9 is an exploded schematic plan view illustrating an embodiment of the display panel and the clad layer of FIG. 5;
FIG. 10 is a schematic cross-sectional view illustrating an embodiment of the clad layer of FIG. 9;
FIGS. 11 to 20 are schematic diagrams illustrating a method of manufacturing a display device according to embodiments of the invention; and
FIGS. 21 to 23 are schematic diagrams illustrating a method of manufacturing a clad layer of a display device according to other embodiments of the invention.

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the invention. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc., (hereinafter individually or collectively referred to as "elements"), of the various embodiments may be otherwise combined, separated, interchanged, and/or rearranged without departing from the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals and/or reference characters denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the X-axis, the Y-axis, and the Z-axis are not limited to three axes of a rectangular coordinate system, such as the x, y, and z axes, and may be interpreted in a broader sense. For example, the X-axis, the Y-axis, and the Z-axis may be perpendicular to one another, or may be different directions that are not perpendicular to one another.

For the purposes of this disclosure, "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc., may be used herein to describe various types of elements, these elements should not be limited by these terms. These terms are used to distinguish one element from another element. Thus, a first element discussed below could be termed a second element without departing from the teachings of the invention.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, parts, and/or modules. Those skilled in the art will appreciate that these blocks, parts, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, parts, and/or modules being implemented by microprocessors or other similar hardware, they may be programmed and controlled using software (e.g., microcode) to perform various functions discussed herein and may optionally be driven by firmware and/or software. It is also contemplated that each block, part, and/or module may be implemented by dedicated hardware, or as a combination of dedicated hardware to perform some functions and a processor (e.g., one or more programmed microprocessors and associated circuitry) to perform other functions. Also, each block, part, and/or module of some embodiments may be physically separated into two or more interacting and discrete blocks, parts, and/or modules without departing from the scope of the invention. Further, the blocks, parts, and/or modules of some embodiments may be physically combined into more complex blocks, parts, and/or modules without departing from the scope of the invention.

Unless otherwise defined or implied herein, all terms (including technical and scientific terms) used herein have the same meaning as commonly understood by those skilled in the art to which this invention pertains. It will be further understood that terms, such as those defined in commonly used dictionaries, should be interpreted as having a meaning that is consistent with their meaning in the context of the relevant art and the invention, and should not be interpreted in an ideal or excessively formal sense unless clearly so defined herein.

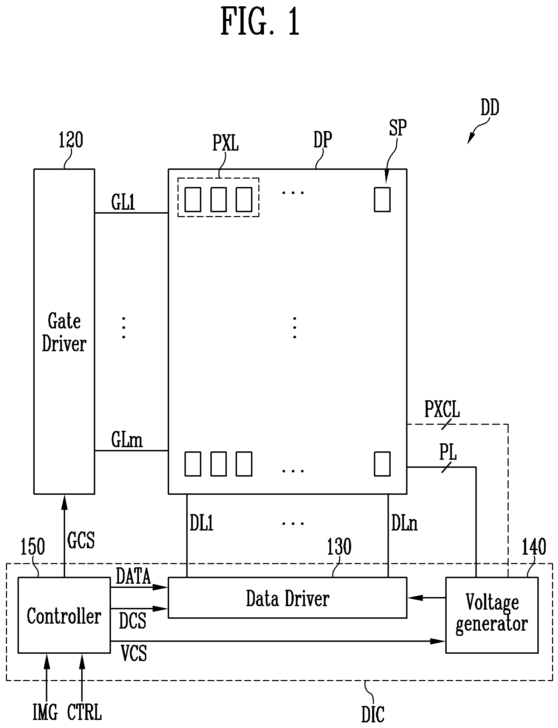

FIG. 1 is a schematic block diagram illustrating an embodiment of a display device according to the invention.

Referring to FIG. 1, the display device DD may include a display panel DP, a gate driver 120, a data driver 130, a voltage generator 140, and a controller 150.

The display panel DP may include sub-pixels SP. The sub-pixels SP may be connected to the gate driver 120 through first to m-th gate lines GL1 to GLm. The sub-pixels SP may be connected to the data driver 130 through first to n-th data lines DL1 to DLn.

The sub-pixels SP may generate light of two or more colors. For example, each of the sub-pixels SP may generate light such as red, green, blue, cyan, magenta, or yellow.

Two or more sub-pixels among the sub-pixels SP may configure a pixel (e.g., single pixel) PXL. For example, the pixel PXL may include three sub-pixels as shown in FIG. 1. As described above, the pixel PXL may emit light of various colors and various luminances according to a combination of light emitted from the sub-pixels included in the pixel PXL.

The gate driver 120 may be connected to the sub-pixels SP arranged in a row direction through the first to m-th gate lines GL1 to GLm. The gate driver 120 may output gate signals to the first to m-th gate lines GL1 to GLm in response to a gate control signal GCS. In embodiments, the gate control signal GCS may include a start signal indicating a start of each frame, a horizontal synchronization signal, and the like.

The gate driver 120 may be disposed on a side (e.g., single side) of the display panel DP. However, embodiments are not limited thereto. For example, the gate driver 120 may be divided into two or more physically and/or logically divided drivers, and the drivers may be disposed on a side (e.g., single side) of the display panel DP and another side of the display panel DP opposite the a side (e.g., single side). As described above, the gate driver 120 may be disposed around the display panel DP in various shapes according to embodiments.

The data driver 130 may be connected to the sub-pixels SP arranged in a column direction through the first to n-th data lines DL1 to DLn. The data driver 130 may receive image data DATA and a data control signal DCS from the controller 150. The data driver 130 operates in response to the data control signal DCS. In embodiments, the data control signal DCS may include a source start signal, a source shift clock, a source output enable signal, and the like.

The data driver 130 may receive voltages from the voltage generator 140. The data driver 130 may apply data signals having grayscale voltages corresponding to the image data DATA to the first to n-th data lines DL1 to DLn using the received voltages. In case that the gate signal is applied to each of the first to m-th gate lines GL1 to GLm, the data signals corresponding to the image data DATA may be applied to the data lines DL1 to DLn. Accordingly, the sub-pixels SP may generate light corresponding to the data signals, and the display panel DP may display an image.

In embodiments, the gate driver 120 and the data driver 130 may include complementary metal-oxide semiconductor (CMOS) circuit elements.

The voltage generator 140 may operate in response to a voltage control signal VCS from the controller 150. The voltage generator 140 may be configured to generate multiple voltages and provide the generated voltages to components of the display device DD, such as the gate driver 120, the data driver 130, and the controller 150. The voltage generator 140 may generate the voltages by receiving an input voltage from an outside of the display device DD and regulating the received voltage.

The voltage generator 140 may generate a first power voltage and a second power voltage. The generated first and second power voltages may be provided to the sub-pixels SP through power lines PL. In an embodiment, at least one of the first and second power voltages may be provided from the outside of the display device DD.

The voltage generator 140 may provide various voltages and/or signals. For example, the voltage generator 140 may provide at least one initialization voltage applied to the sub-pixels SP. For example, during a sensing operation for sensing electrical characteristics of transistors and/or light emitting elements of the sub-pixels SP, a reference voltage (e.g., predetermined or selectable reference voltage) may be applied to the first to n-th data lines DL1 to DLn, and the voltage generator 140 may generate the reference voltage and transmit the reference voltage to the data driver 130. For example, during a display operation for displaying an image on the display panel DP, common pixel control signals may be applied to the sub-pixels SP, and the voltage generator 140 may generate the pixel control signals. In embodiments, the voltage generator 140 may provide the pixel control signals to the sub-pixels SP through pixel control lines PXCL. In FIG. 1, the pixel control lines PXCL may be connected between the voltage generator 140 and the display panel DP, but embodiments are not limited thereto. For example, the pixel control lines PXCL may be connected between the gate driver 120 and the display panel DP. The pixel control signals may be transmitted from the voltage generator 140 to the pixel control lines PXCL through the gate driver 120.

The controller 150 controls overall operations of the display device DD. The controller 150 may receive input image data IMG and a control signal CTRL corresponding thereto from the outside. The controller 150 may provide the gate control signal GCS, the data control signal DCS, and the voltage control signal VCS in response to the control signal CTRL.

The controller 150 may convert the input image data IMG so that the input image data IMG may be suitable for the display device DD or the display panel DP and output the image data DATA. In embodiments, the controller 150 may output the image data DATA by aligning the input image data IMG so that the input image data IMG may be suitable for the sub-pixels SP of a row part.

Two or more components of the data driver 130, the voltage generator 140, and the controller 150 may be mounted on an integrated circuit (e.g., single integrated circuit). As shown in FIG. 1, the data driver 130, the voltage generator 140, and the controller 150 may be included in a driver integrated circuit DIC. The data driver 130, the voltage generator 140, and the controller 150 may be functionally divided components in a driver integrated circuit DIC (e.g., single driver integrated circuit DIC). In other embodiments, at least one of the data driver 130, the voltage generator 140, and the controller 150 may be provided as a component distinguished from the driver integrated circuit DIC.

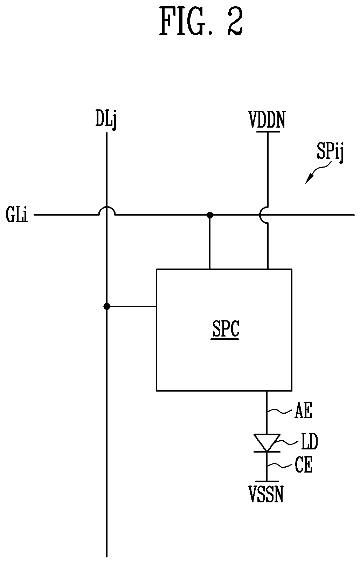

FIG. 2 is a schematic block diagram illustrating an embodiment of one of the sub-pixels of FIG. 1. In FIG. 2, among the sub-pixels SP of FIG. 1, a sub-pixel SPij arranged in an i-th row (i may be an integer greater than or equal to 1 and less than or equal to m) and a j-th column (j may be an integer greater than or equal to 1 and less than or equal to n) is shown as an example.

Referring to FIG. 2, the sub-pixel SPij may include a sub-pixel circuit SPC and a light emitting element LD.

The light emitting element LD may be connected between a first power voltage node VDDN and a second power voltage node VSSN. The first power voltage node VDDN may be connected to one of the power lines PL of FIG. 1 and may receive the first power voltage. The second power voltage node VSSN may be connected to another one of the power lines PL of FIG. 1 and may receive the second power voltage. The first power voltage may have a voltage level higher than that of the second power voltage.

The light emitting element LD may be connected between an anode electrode AE and a cathode electrode CE. The anode electrode AE may be connected to the first power voltage node VDDN through the sub-pixel circuit SPC. For example, the anode electrode AE may be connected to the first power voltage node VDDN through at least one transistors included in the sub-pixel circuit SPC. The cathode electrode CE may be connected to the second power voltage node VSSN. The light emitting element LD may be configured to emit light according to a current flowing from the anode electrode AE to the cathode electrode CE.

The sub-pixel circuit SPC may be connected to an i-th gate line GLi among the first to m-th gate lines GL1 to GLm of FIG. 1, and a j-th data line DLj among the first to n-th data lines DL1 to DLn of FIG. 1. In response to a gate signal received through the i-th gate line GLi, the sub-pixel circuit SPC may control the light emitting element LD to emit light according to a data signal received through the j-th data line DLj. In embodiments, the sub-pixel circuit SPC may be further connected to the pixel control lines PXCL of FIG. 1. The sub-pixel circuit SPC may control the light emitting element LD in further response to the pixel control signals received through the pixel control lines PXCL.

For such operations, the sub-pixel circuit SPC may include circuit elements, for example, transistors and at least one capacitor.

The transistors of the sub-pixel circuit SPC may include P-type transistors and/or N-type transistors. In embodiments, the transistors of the sub-pixel circuit SPC may include a metal oxide silicon field effect transistor (MOSFET). In embodiments, the transistors of the sub-pixel circuit SPC may include an amorphous silicon semiconductor, a monocrystalline silicon, a polycrystalline silicon semiconductor, an oxide semiconductor, and the like.

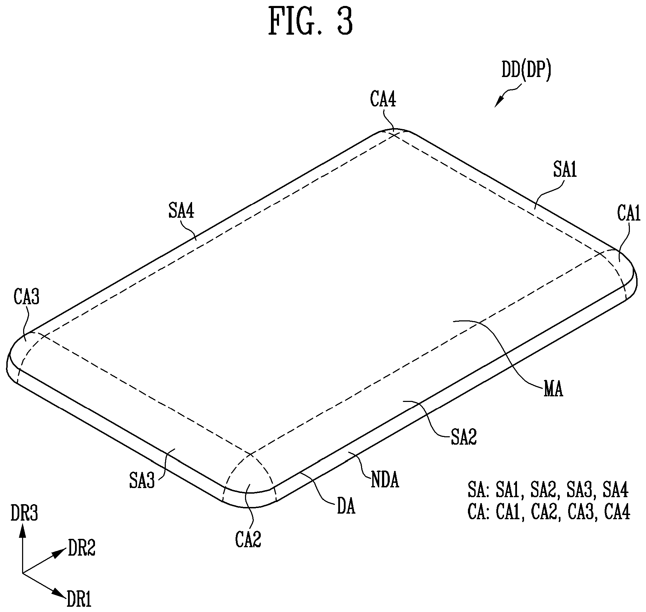

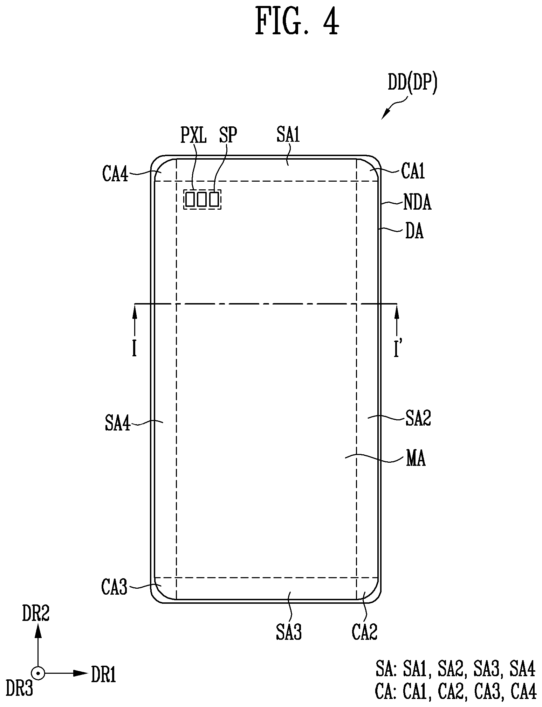

FIG. 3 is a schematic plan view illustrating an embodiment of the display device of FIG. 1. FIG. 4 is a plan view illustrating an embodiment of the display device of FIG. 3.

Referring to FIGS. 3 and 4, the display panel DP may include a display area DA and a non-display area NDA. The display panel DP may display an image through the display area DA. The non-display area NDA may be disposed around the display area DA, and may be a dead space that does not display an image.

The display panel DP may include multiple sub-pixels SP in the display area DA. The sub-pixels SP may be arranged in a first direction DR1 and a second direction DR2 intersecting the first direction DR1. For example, the sub-pixels SP may be arranged in a matrix form in the first direction DR1 and the second direction DR2. As another example, the sub-pixels SP may be arranged in a zigzag form in the first direction DR1 and the second direction DR2. An arrangement of the sub-pixels SP may vary according to embodiments. The first direction DR1 may be a row direction, and the second direction DR2 may be a column direction.

Two or more sub-pixels among the sub-pixels SP may configure a pixel PXL (e.g., single pixel PXL). In FIG. 4, the pixel PXL may be shown as including a first sub-pixel SP1, a second sub-pixel SP2, and a third sub-pixel SP3, but embodiments are not limited thereto. For example, the pixel PXL may include two sub-pixels. For example, each of the first sub-pixel SP1, the second sub-pixel SP2, and the third sub-pixel SP3 may generate light of one of various colors such as red, green, blue, cyan, magenta, and yellow.

A component for controlling the sub-pixels SP may be disposed in the non-display area NDA. Lines connected to the sub-pixels SP, for example, the first to m-th gate lines GL1 to GLm of FIG. 1, the first to n-th data lines DL1 to DLn, the power lines PL, and the pixel control lines PXCL may be disposed in the non-display area NDA.

At least one of the gate driver 120, the data driver 130, the voltage generator 140, and the controller 150 of FIG. 1 may be disposed in the non-display area NDA of the display panel DP. In embodiments, the gate driver 120 may be disposed in the non-display area NDA. The data driver 130, the voltage generator 140, and the controller 150 may be implemented as a driver integrated circuit DIC of FIG. 1 separate from the display panel DP, and the driver integrated circuit DIC may be connected to the lines disposed in the non-display area NDA. In other embodiments, the gate driver 120 may be implemented as an integrated circuit (e.g., single integrated circuit) separate from the display panel DP, together with the data driver 130, the voltage generator 140, and the controller 150.

In embodiments, the display area DA may have various shapes. The display area DA may have a closed loop shape including sides of a straight line and/or a curved line. For example, the display area DA may have shapes of a polygon, a circle, a semicircle, an ellipse, and the like.

In embodiments, the display panel DP may have a shape in which at least one area may be curved. At this time, the curved area of the display panel DP may refer to an area having curvature. The curved area of the display panel DP may include both of a single curved surface and a plurality of curved surfaces. The single curved surface may refer to a portion forming a curvature (e.g., single curvature), and the plurality curved surface may refer to a portion forming multiple curvatures. The display panel DP may include a main area MA, an auxiliary area SA, and a corner area CA.

The main area MA may include the pixel PXL as a substantially flat area, and may display an image.

The auxiliary area SA may be curved downward from at least an edge (e.g., single edge) of the main area MA, may partially or entirely include the pixel PXL, and may display an image. The auxiliary area SA may be a single curved surface.

**For** example, the auxiliary area SA may include a first auxiliary area SA1, a second auxiliary area SA2, a third auxiliary area SA3, and a fourth auxiliary area SA4. The first auxiliary area SA1, the second auxiliary area SA2, the third auxiliary area SA3, and the fourth auxiliary area SA4 may be curved downward from four edges of the main area MA, respectively.

The corner area CA may be disposed at a position where neighboring auxiliary areas SA meet, may partially or entirely include the pixel PXL, and may display an image. The corner area CA may be a plurality of curved surfaces. For example, the corner area CA may include a first corner area CA1, a second corner area CA2, a third corner area CA3, and a fourth corner area CA4. The first corner area CA1 may be disposed at a position where the first auxiliary area SA1 and the second auxiliary area SA2 meet, the second corner area CA2 may be disposed at a position where the second auxiliary area SA2 and the third auxiliary area SA3 meet, the third corner area CA3 may be disposed at a position where the third auxiliary area SA3 and the fourth auxiliary area SA4 meet, and fourth second corner area CA4 may be disposed at a position where the fourth auxiliary area SA4 and the first auxiliary area SA1 meet.

Therefore, in case that the planar area of the display panel DP is the same, as curvature of the auxiliary area SA increases (or radius of curvature of the auxiliary area SA decreases), the area of the auxiliary area SA and the area of the corner area CA in a plan view may decrease, and the area of the main area MA may increase.

For example, the entire main area MA and a portion of the auxiliary area SA and the corner area CA may correspond to the display area DA, and a remaining portion of the auxiliary area SA and the corner area CA may correspond to the non-display area NDA. However, embodiments according to the invention are not limited thereto, and the entire main area MA, auxiliary area SA, and corner area CA may correspond to the display area DA.

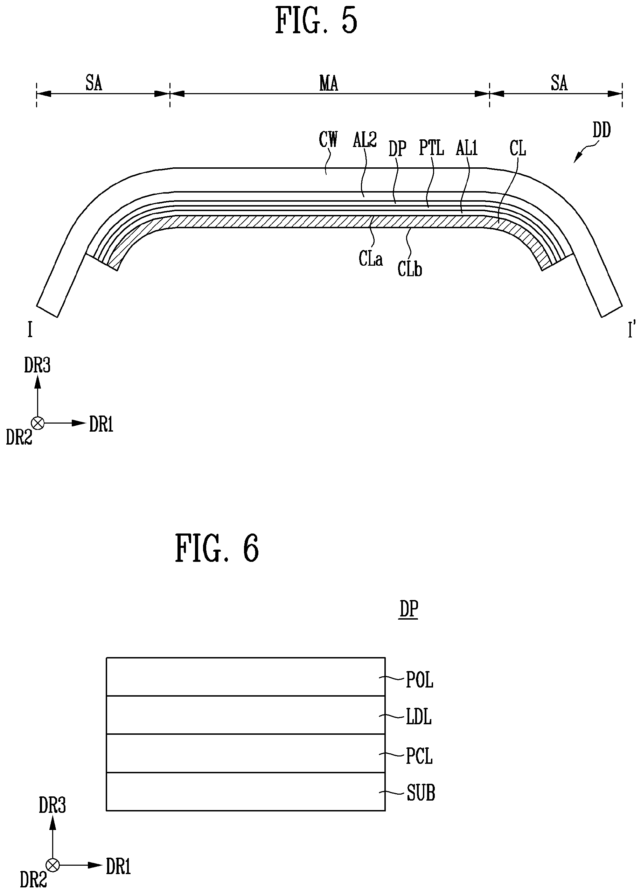

**FIG.** 5 is a schematic cross-sectional view taken along line I-I' of FIG. 4. FIG. 6 is a schematic cross-sectional view illustrating an embodiment of the display panel of FIG. 5.

Referring to FIG. 5, the display device DD may include a display panel DP, a protective layer PTL, a first adhesive layer AL1, a clad layer CL, a second adhesive layer AL2, and a cover window CW.

The display panel DP may include the pixel PXL of FIG. 4. As the display device DD has the shape in which at least one area may be curved and may include the main area MA, the auxiliary area SA, and the corner area CA, the display panel DP also may have a shape in which at least one area may be curved and may include the main area MA, the auxiliary area SA, and the corner area CA.

In embodiments, the display panel DP may be bendable, foldable, or rollable. In these cases, the display panel DP and/or a substrate of the display panel DP may include materials having a flexible property.

Referring to FIG. 6, the display panel DP may include a substrate SUB, a pixel circuit layer PCL, a light emitting element layer LDL, and a polarizing plate POL.

The substrate SUB may be formed of an insulating material such as glass or resin. For example, the substrate SUB may include a glass substrate. As another example, the substrate SUB may include a polyimide (PI) substrate. As still another example, the substrate SUB may include a silicon wafer substrate formed using a semiconductor process.

The pixel circuit layer PCL may be disposed on the substrate SUB. The pixel circuit layer PCL may include insulating layers and semiconductor patterns and conductive patterns disposed between the insulating layers. The conductive patterns of the pixel circuit layer PCL may function as circuit elements, lines, and the like.

The circuit elements of the pixel circuit layer PCL may include a sub-pixel circuit of each of the sub-pixels SP. In other words, the circuit elements of the pixel circuit layer PCL may be provided as transistors and at least one capacitor of the sub-pixel circuit.

The lines of the pixel circuit layer PCL may include lines connected to the sub-pixels SP. The lines of the pixel circuit layer PCL may include various signal lines and/or voltage lines desirable for driving the light emitting element layer LDL.

The light emitting element layer LDL may be disposed on the pixel circuit layer PCL. In an embodiment, the light emitting element layer LDL may include a light emitting element. According to an embodiment, the light emitting element may include an organic light emitting diode (OLED). As another example, according to an embodiment, the light emitting element may include an inorganic light emitting element including an inorganic material. As another example, according to an embodiment, the light emitting element layer LDL may include a liquid crystal display (LCD). However, the invention is not limited thereto.

The polarizing plate POL may be disposed on the light emitting element layer LDL. The polarizing plate POL may be disposed to reduce reflection of external light. However, in an embodiment according to the invention, the polarizing plate POL may be omitted.

Referring to FIG. 5 again, the second adhesive layer AL2 and the cover window CW may be disposed on the display panel DP. The cover window CW may be attached to the display panel DP through the second adhesive layer AL2. The second adhesive layer AL2 may include an optically clear adhesive (OCA).

The cover window CW may cover the display panel DP and may transmit an image displayed on the display panel DP. The cover window CW may protect the display panel DP from external shock and the like. Therefore, the cover window CW may include a transparent and hard material such as glass or plastic. An area of the cover window CW corresponding to the curved area of the display panel DP may also be curved.

The protective layer PTL may be disposed under the display panel DP. The protective layer PTL may protect the display panel DP during a manufacturing process of the display device DD, or the like. The protective layer PTL may overlap an entirety of the display panel DP. The protective layer PTL may be attached to the display panel DP through an adhesive layer, but embodiments according to the invention are not limited thereto.

The first adhesive layer AL1 and the clad layer CL may be disposed under the protective layer PTL. The clad layer CL may be attached to the protective layer PTL through the first adhesive layer AL1. The first adhesive layer AL1 may include a pressure sensitive adhesive (PSA). However, embodiments according to the invention are not limited thereto.

The clad layer CL may overlap an entirety of the display panel DP including the curved area (for example, the auxiliary area SA and the corner area CA of the display panel DP). Specifically, among an upper surface CLa and a lower surface CLb of the clad layer CL, the upper surface CLa of the clad layer CL adjacent to the display panel DP may overlap an entirety of the display panel DP. The clad layer CL may overlap an entirety of the display panel DP, may support the display panel DP, and may assist so that the display panel DP may be formed without deformation during the manufacturing process of the display device DD.

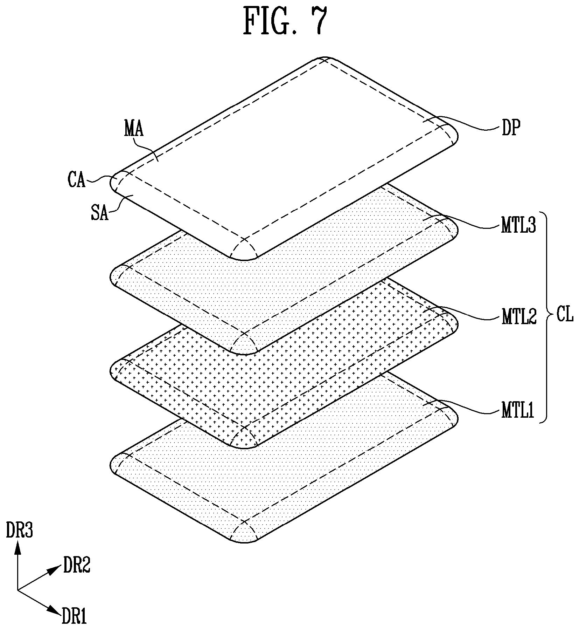

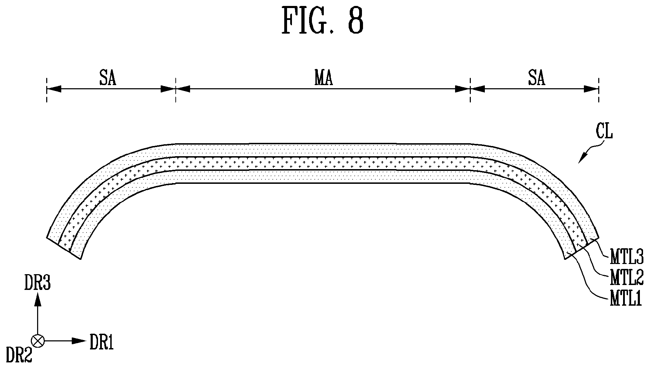

FIG. 7 is an exploded schematic plan view illustrating an embodiment of the display panel and the clad layer of FIG. 5. FIG. 8 is a schematic cross-sectional view illustrating an embodiment of the clad layer of FIG. 7.

Referring to FIGS. 7 and 8, the clad layer CL may have a structure in which two or more metal layers including different metals may be clad bonded. Therefore, the clad layer CL may have characteristics of all the metals included in the clad layer CL.

For example, the clad layer CL may include a first metal layer MTL1, a second metal layer MTL2, and a third metal layer MTL3. The first metal layer MTL1 may include a first metal. The second metal layer MTL2 may be disposed on the first metal layer MTL1 and may include a second metal different from the first metal. The third metal layer MTL3 may be disposed on the second metal layer MTL2 and may include the first metal. The first metal layer MTL1 and the third metal layer MTL3 may include a same material, and the second metal layer MTL2 may include a material different from that of the first metal layer MTL1 and the third metal layer MTL3. However, embodiments according to the invention are not limited thereto.

In embodiments, in order for the clad layer CL to secure both strength and flexibility, one of the first metal and the second metal may be selected as a metal with relatively high strength, and another may be selected as a metal with relatively a high strength and high malleability. For example, a strength of the first metal may be greater than a strength of the second metal. A strength of each of the first metal layer MTL1 and the third metal layer MTL3 may be greater than a strength of the second metal layer MTL2. For example, ductility of the second metal may be greater than ductility of the first metal. Ductility of the second metal layer MTL2 may be greater than ductility of each of the first metal layer MTL1 and the third metal layer MTL3.

Since the first metal layer MTL1 and the third metal layer MTL3 include the same metal, and only the second metal layer MTL2 may include a different metal, the clad layer CL may have a uniform characteristic in a third direction DR3 crossing the first direction DR1 and the second direction DR2. Therefore, in case of forming the clad layer CL during manufacturing of the display device DD, the clad layer CL may not be biased to a side (e.g., single side) and may be formed in a preset shape. Since the first metal layer MTL1 and the third metal layer MTL3 may include the first metal with high strength and since the second metal layer MTL2 may include the second metal with high ductility, the clad layer CL may be readily molded and may have a robust property.

For example, the first metal may be at least one of nickel (Ni) and a stainless steel, and the second metal may be copper. However, embodiments according to the invention are not limited thereto.

In embodiments, the first metal layer MTL1, the second metal layer MTL2, and the third metal layer MTL3 may overlap an entirety of the display panel DP. The clad layer CL and the display panel DP may overlap an entirety of each other, and the first metal layer MTL1, the second metal layer MTL2, and the third metal layer MTL3 included in the clad layer CL may also overlap an entirety of the display panel DP. Therefore, the clad layer CL may entirely support the display panel DP at a lower portion of the display panel DP, and may prevent the display panel DP from being deformed in case that the display panel DP is molded.

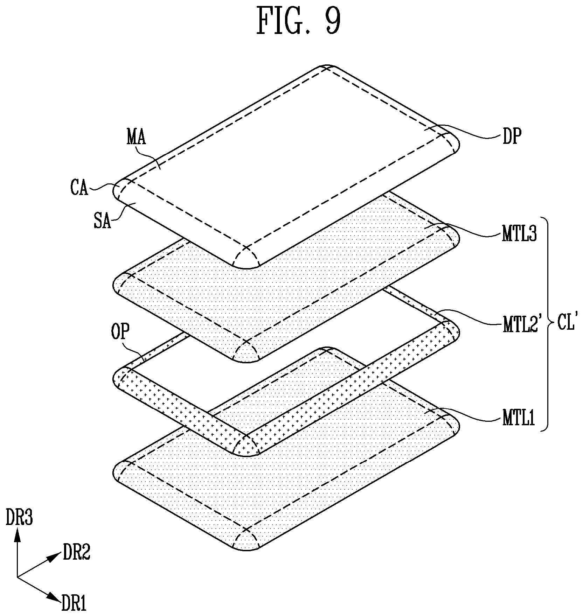

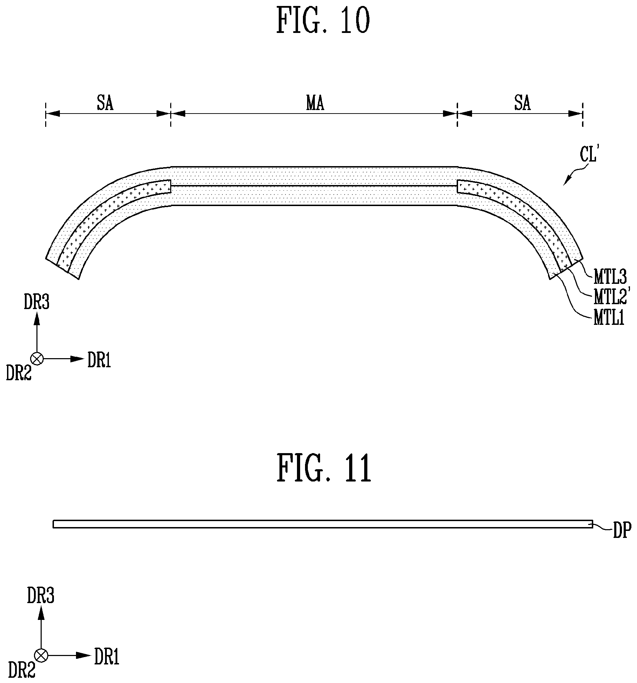

FIG. 9 is an exploded schematic plan view illustrating an embodiment of the display panel different from the clad layer of FIG. 5. FIG. 10 is a schematic cross-sectional view illustrating an embodiment of the clad layer of FIG. 9.

The clad layer CL' according to the embodiment may be different from the clad layer CL described above in a shape of the second metal layer MTL2. Therefore, subject matter that overlaps the subject matter described above is briefly described or is not repeated.

Referring to FIGS. 9 and 10, the clad layer CL' may have a structure in which two or more metal layers including different metals are clad bonded.

For example, the clad layer CL' may include a first metal layer MTL1, a second metal layer MTL2', and a third metal layer MTL3. The first metal layer MTL1 may include a first metal. The second metal layer MTL2' may be disposed on the first metal layer MTL1 and may include a second metal different from the first metal. The third metal layer MTL3 may be disposed on the second metal layer MTL2' and may include the first metal.

In embodiments, the first metal layer MTL1 and the third metal layer MTL3 may overlap an entirety of the display panel DP. The second metal layer MTL2' may overlap only a portion of the display panel DP. Specifically, the second metal layer MTL2' may overlap the auxiliary area SA and the corner area CA of the display panel DP in a plan view, and may be spaced apart from the main area MA. The clad layer CL' may overlap an entirety of the display panel DP, but the second metal layer MTL2' included in the clad layer CL' may overlap the display panel DP in only the auxiliary area SA and the corner area CA and may not overlap the display panel DP in the main area MA. At this time, the second metal layer MTL2' may define an opening OP that overlaps the main area MA. However, embodiments according to the invention are not limited thereto, and the second metal layer MTL2' may have multiple plate shapes that overlap the auxiliary area SA and the corner area CA, respectively.

In embodiments, the first metal layer MTL1 may have a thinner thickness in the auxiliary area SA and the corner area CA than in the main area MA. The third metal layer MTL3 may have a thinner thickness in the auxiliary area SA and the corner area CA than in the main area MA.

Since the clad layer CL' overlaps an entirety of the display panel DP, but the second metal layer MTL2' overlaps only the auxiliary area SA and the corner area CA, a thickness of the display device in the main area MA may be reduced, and a material cost for the second metal may be reduced.

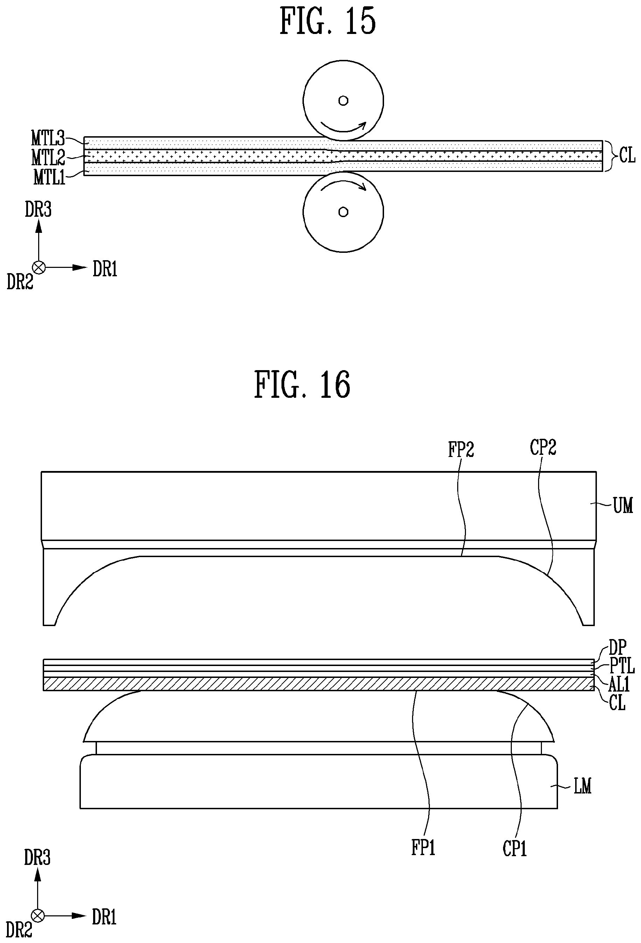

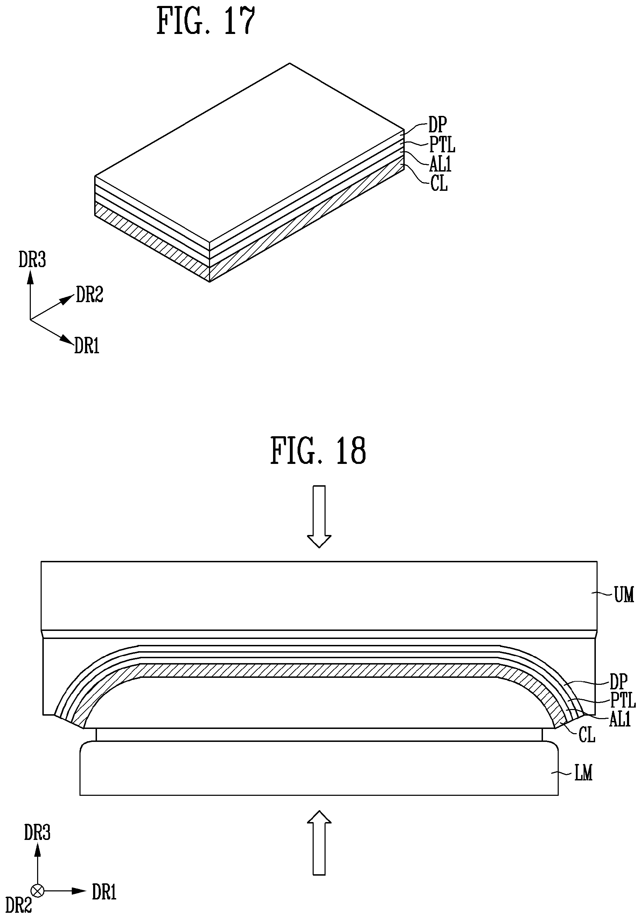

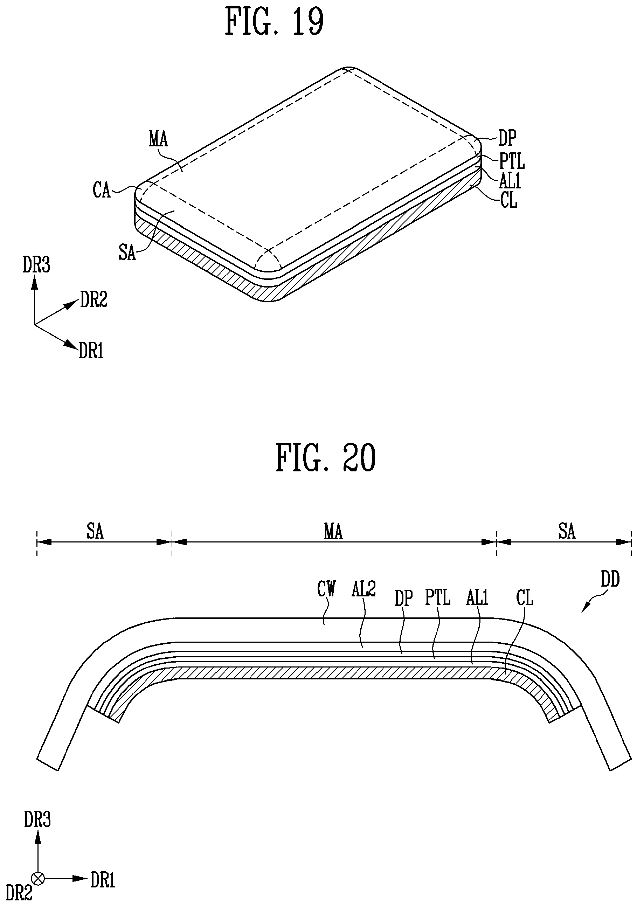

FIGS. 11 to 20 are schematic diagrams illustrating a method of manufacturing a display device according to embodiments of the invention. FIGS. 11 to 20 illustrate a method of manufacturing the display device DD according to the embodiment described above with reference to FIGS. 1 to 8. FIG. 17 is a schematic plan view illustrating an embodiment of the display panel DP, the protective layer PTL, the first adhesive layer AL1, and the clad layer CL of FIG. 16. FIG. 19 is a schematic plan view illustrating an embodiment of the display panel DP, the protective layer PTL, the first adhesive layer AL1, and the clad layer CL of FIG. 18. Subject matter that overlaps the subject matter described above is briefly described or is not repeated.

Referring to FIG. 11, the display panel DP may be formed. The display panel DP may be formed by forming the substrate SUB of FIG. 2, the pixel circuit layer PCL on the substrate SUB, the light emitting element layer LDL on the pixel circuit layer PCL, and the polarizing plate POL on the light emitting element layer LDL.

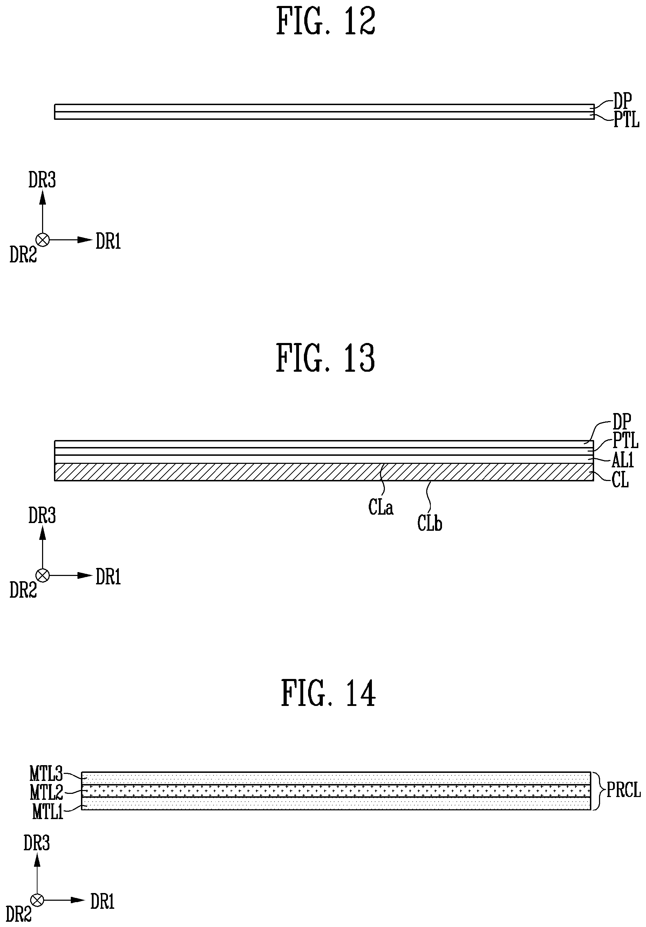

Referring to FIG. 12, the protective layer PTL may be formed under the display panel DP. The protective layer PTL may be attached to a lower portion of the display panel DP.

Referring to FIG. 13, the first adhesive layer AL1 and the clad layer CL may be formed under the protective layer PTL. The clad layer CL may be formed to overlap the entire area including the auxiliary area SA and the corner area CA of the display panel DP. Specifically, of the upper surface CLa and the lower surface CLb of the clad layer CL, the upper surface CLa of the clad layer CL adjacent to the display panel DP may be formed to overlap an entirety of the display panel DP. The clad layer CL may be attached to the protective layer PTL through the first adhesive layer AL1. The first adhesive layer AL1 may be formed of pressure sensitive adhesive (PSA). However, embodiments according to the invention are not limited thereto.

The clad layer CL may be formed in advance before being attached to a lower portion of the protective layer PTL. In embodiments, the clad layer CL may be formed by clad bonding (or cladding) two or more metal layers including different metals.

Referring to FIG. 14, the first metal layer MTL1, the second metal layer MTL2, and the third metal layer MTL3 may be sequentially stacked on each other to form a preliminary clad layer PRCL. The first metal layer MTL1, the second metal layer MTL2, and the third metal layer MTL3 may be formed to overlap an entirety of the display panel DP of FIG. 13.

The first metal layer MTL1 may be formed of the first metal, the second metal layer MTL2 may be formed of the second metal different from the first metal, and the third metal layer MTL3 may be formed of the first metal. At this time, the strength of the first metal may be greater than the strength of the second metal, and the ductility of the second metal may be greater than the ductility of the first metal. For example, the first metal may be one of nickel and stainless steel, and the second metal may be copper.

Referring to FIG. 15, the clad layer CL may be formed by rolling the preliminary clad layer PRCL including the first metal layer MTL1, the second metal layer MTL2, and the third metal layer MTL3. By rolling the preliminary clad layer PRCL, the metals included in the first metal layer MTL1, the second metal layer MTL2, and the third metal layer MTL3 may be bonded to each other. The first metal layer MTL1, the second metal layer MTL2, and the third metal layer MTL3 may be clad bonded to form the clad layer CL including three metal layers. Since the clad layer CL may be formed by combining two or more metals, the clad layer CL may have all characteristics of two or more metals.

Referring to FIGS. 16 to 19, a curved area may be formed by thermoforming the display panel DP, the protective layer PTL, the first adhesive layer AL1, and the clad layer CL attached to each other.

Specifically, the display panel DP, the protective layer PTL, the first adhesive layer AL1, and the clad layer CL may be molded by being pressed between a lower mold LM and an upper mold UM.

The lower mold LM may have the same shape as a lower surface of the display device to be formed. For example, the lower mold LM may include a first substantially flat portion FP1 corresponding to the main area MA of the display device of FIG. 4 and a first curved portion CP1 corresponding to the auxiliary area SA and the corner area CA. An upper surface of the lower mold LM may have a shape that protrudes in a direction of the upper mold UM, that is, in the third direction DR3.

The upper mold UM may have the same shape as an upper surface of the display device to be formed. For example, the upper mold UM may include a second substantially flat portion FP2 corresponding to the main area MA of the display device of FIG. 4 and a second curved portion CP2 corresponding to the auxiliary area SA and the corner area CA. A lower surface of the upper mold UM may have a concave shape in the third direction DR3.

The display panel DP, the protective layer PTL, the first adhesive layer AL1, and the clad layer CL may be disposed between the lower mold LM and the upper mold UM on the lower mold LM. Thereafter, by engaging the lower mold LM and the upper mold UM, the lower mold LM and the upper mold UM may apply pressure to the display panel DP, the protective layer PTL, the first adhesive layer AL1, and the clad layer CL. At this time, the lower mold LM and the upper mold UM may not only apply pressure but may also apply heat to the display panel DP, the protective layer PTL, the first adhesive layer AL1, and the clad layer CL.

Accordingly, the display panel DP, the protective layer PTL, the first adhesive layer AL1, and the clad layer CL may be thermoformed as a shape of the lower mold LM and the upper mold UM, and thus a curved area may be formed in each of the display panel DP, the protective layer PTL, the first adhesive layer AL1, and the clad layer CL. The main area MA, the auxiliary area SA curved downward from the edge of the main area MA, and the corner area CA disposed where the neighboring auxiliary areas SA meet may be formed in each of the display panel DP, the protective layer PTL, the first adhesive layer AL1, and the clad layer CL.

Referring to FIG. 20, after thermoforming, the second adhesive layer AL2 and the cover window CW may be formed on the display panel DP. The cover window CW may be attached to the display panel DP through the second adhesive layer AL2. The second adhesive layer AL2 may be formed of an optically clear adhesive, and the cover window CW may be formed of glass or plastic.

An area of the cover window CW corresponding to the curved area (for example, the auxiliary area SA and the corner area CA) of the display panel DP may also be curved, and thus the cover window CW may be readily attached to the display panel DP.

Therefore, the display device DD including the cover window CW, the second adhesive layer AL2, the display panel DP, the protective layer PTL, the first adhesive layer AL1, and the clad layer CL may be formed.

In embodiments, since the clad layer CL in which two or more metals are clad bonded is disposed under the display panel DP and thermoformed, the display panel DP may be prevented from being deformed in case of thermoforming the clad layer CL. As the clad layer CL may be entirely disposed under the display panel DP, a thickness of a thermoformed structure may be increased, and thus a critical load may increase. Therefore, a buckling phenomenon of the display panel DP may be prevented. Since the clad layer CL has deformation resistance during thermoforming, the display panel DP may be prevented from being deformed by shrinkage due to heat. Therefore, the display panel DP may be curved with a relatively high curvature without being deformed, and thus the area consumed in a plan view of the non-display area positioned at the edge of the display panel DP may be reduced.

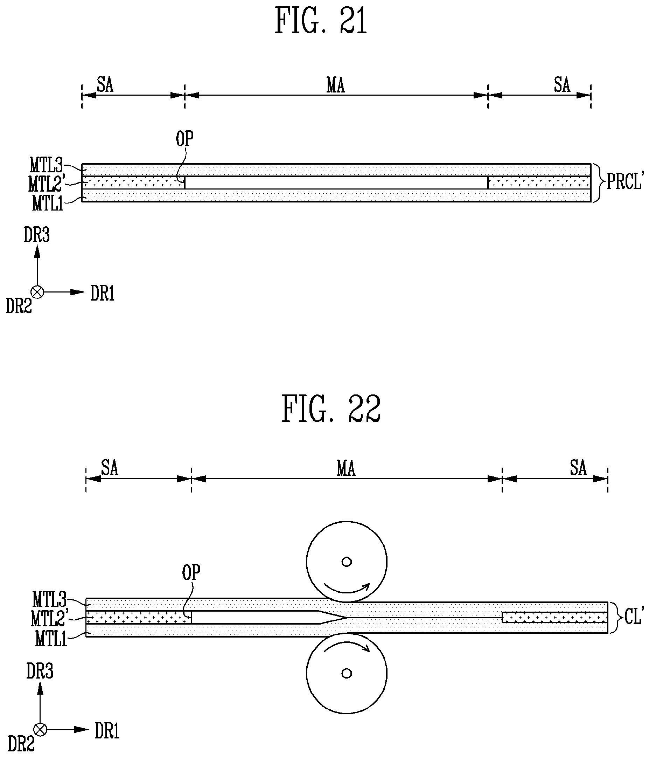

FIGS. 21 to 23 are schematic diagrams illustrating a method of manufacturing a clad layer of a display device according to other embodiments of the invention. FIGS. 21 to 23 illustrate a method of manufacturing the clad layer CL' of the display device according to the embodiment described above with reference to FIGS. 9 and 10.

The method of manufacturing the clad layer CL' of the display device according to the embodiment of FIGS. 9-10 may be different from the method of manufacturing the clad layer CL of the display device described above in FIGS. 7-8 in the shape of the second metal layer MTL2. Therefore, subject matter overlapping the subject matter described above is briefly described or is not repeated.

Referring to FIG. 21, the first metal layer MTL1, the second metal layer MTL2', and the third metal layer MTL3 may be sequentially stacked on each other to form a preliminary clad layer PRCL'.

The first metal layer MTL1 and the third metal layer MTL3 may be formed to overlap an entirety of the display panel DP. In contrast, the second metal layer MTL2' may be formed to overlap the auxiliary area SA and the corner area CA of the display panel (for example, the display panel DP of FIG. 20) in a plan view, and may be formed to be spaced apart from the main area MA. The opening OP that does not overlap the main area MA of the display panel and corresponds to the main area MA of the display panel may be formed in the second metal layer MTL2'.

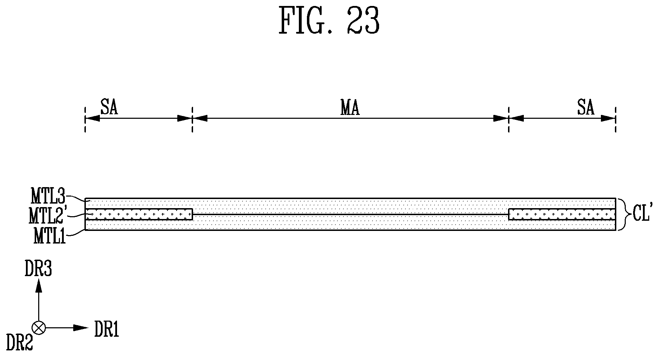

Referring to FIGS. 22 and 23, the clad layer CL' may be formed by rolling the preliminary clad layer PRCL' including the first metal layer MTL1, the second metal layer MTL2, and the third metal layer MTL3. By rolling the preliminary clad layer CL', the metals included in the first metal layer MTL1, the second metal layer MTL2', and the third metal layer MTL3 may be bonded to each other. The first metal layer MTL1, the second metal layer MTL2', and the third metal layer MTL3 may be clad bonded to each other to form the clad layer CL'. Therefore, an area of the clad layer CL' corresponding to the auxiliary area SA and the corner area CA of the display panel may be formed as a three-layered clad metal layer in which the first metal layer MTL1, the second metal layer MTL2', and the third metal layer MTL3 may be rolled, and an area of the clad layer CL' corresponding to the main area MA may be formed as a two-layered clad metal layer in which the first metal layer MTL1 and the third metal layer MTL3 may be rolled.

Accordingly, thicknesses of each area of the clad layer CL' may be different from each other, and characteristics (for example, strength, ductility, and the like) of each area may also be different from each other. By disposing the second metal layer MTL2' only in the auxiliary area SA and the corner area CA where both of strength and ductility are required, a thickness of the display device corresponding to the main area MA may be reduced, and a material cost may be reduced. In the auxiliary area SA and the corner area CA where a mold may be required, the clad layer CL' may be readily formed by the second metal layer MTL2' having high ductility, and the display panel may be prevented from being deformed in case of molding the display panel by support of the first metal layer MTL1 and the third metal layer MTL3.

Although the technical idea of the invention has been described in detail according to the above-described embodiments, it should be noted that the above-described embodiments are for description and not limitation. Those skilled in the art will understand that various modifications are possible in the scope of the technical idea of the invention.

The scope of the invention is not limited to the details described in the detailed description of the specification, but should be defined by the claims.

## Claims

1. A display device (DD) comprising:
a display panel (DP) including a curved area; and
a clad layer (CL, CL') disposed under the display panel (DP), overlapping the curved area of the display panel (DP), and having a plurality of metal layers (MTL1, MTL2, MTL2', MTL3) that include different metals that are clad bonded to each other,
wherein a surface of the clad layer (CL, CL') adjacent to the display panel (DP) overlaps an entirety of the display panel (DP).

2. The display device (DD) of claim 1, wherein the display panel (DP) comprises:
a main area (MA);
a plurality of auxiliary areas (SA) curved downward from an edge portion of the main area (MA); and
a corner area (CA) disposed where neighboring ones of the plurality of auxiliary areas (SA) meet.

3. The display device (DD) of claim 2, wherein the clad layer (CL, CL') overlaps the plurality of auxiliary areas (SA) and the corner area (CA).

4. The display device (DD) of at least one of claims 1 to 3, wherein the clad layer (CL, CL') comprises:
a first metal layer (MTL1) including a first metal;
a second metal layer (MTL2, MTL2') disposed on the first metal layer (MTL1) and including a second metal different from the first metal; and
a third metal layer (MTL3) disposed on the second metal layer (MTL2, MTL2') and including the first metal.

5. The display device (DD) of claim 4, wherein a strength of the first metal is greater than a strength of the second metal.

6. The display device (DD) of claim 4 or 5, wherein a ductility of the second metal is greater than a ductility of the first metal.

7. The display device (DD) of at least one of claims 4 to 6, wherein the first metal includes at least one of nickel and stainless steel.

8. The display device (DD) of claim 7, wherein the second metal includes copper.

9. The display device (DD) of at least one of claims 4 to 8, wherein
the first metal layer (MTL1), the second metal layer (MTL2), and
the third metal layer (MTL3) overlaps an entirety of the display panel (DP).

10. The display device (DD) of claim 2 and at least one of claims 4 to 8, wherein the first metal layer (MTL1) and the third metal layer (MTL3) overlap an entirety of the display panel (DP), and
the second metal layer (MTL2') overlaps the plurality of auxiliary areas (SA) and the corner area (CA) of the display panel (DP) in a plan view without overlapping the main area (MA).

11. The display device (DD) of at least one of claims 1 to 10, wherein the curved area of the display panel (DP) and the clad area are thermoformed.

12. A method of manufacturing a display device (DD), especially a display device (DD) according to at least one of claims 1 to 11, the method comprising:
forming a display panel (DP);
forming a clad layer (CL, CL') under the display panel (DP), the clad layer (CL, CL') including a plurality of metal layers (MTL1, MTL2, MTL2', MTL3) that include different metals that are clad bonded to each other; and
forming a curved area by thermoforming the display panel (DP) and the clad layer (CL, CL'),
wherein a surface of the clad layer (CL, CL') adjacent to the display panel (DP) overlaps an entirety of the display panel (DP).

13. The method of claim 12, further comprising:
attaching the clad layer (CL, CL') to the display panel (DP) after the forming of the clad layer (CL, CL').

14. The method of claim 13, wherein the curved area is formed by thermoforming the display panel (DP) and the clad layer (CL, CL') after attaching the clad layer (CL, CL') to the display panel (DP).

15. The method of at least one of claims 12 to 14, wherein the forming of the clad layer (CL, CL') comprises:
forming a first metal layer (MTL1);
forming a second metal layer (MTL2, MTL2') on the first metal layer (MTL1);
forming a third metal layer (MTL3) on the second metal layer (MTL2, MTL2'); and
clad bonding the first metal layer (MTL1), the second metal layer (MTL2, MTL2'), and the third metal layer (MTL3) to each other by rolling the first metal layer (MTL1), the second metal layer (MTL2, MTL2'), and the third metal layer (MTL3).
